# EUROPEAN PATENT APPLICATION

(11) **EP 3 089 210 A1**
(43) Date of publication of application: **02.11.2016**
(21) Application number: 15201672.1
(22) Date of filing: 21.12.2015
(51) Int. Cl.: H01L 23/427, H01L 23/473

(54) **COOLING MODULE, WATER-COOLED COOLING MODULE AND COOLING SYSTEM**

(30) Priority: 30.04.2015 CN 201520275240 U
(71) Applicant: Cooler Master Co., Ltd., New Taipei City 235 (TW)
(72) Inventor: SUN, Chien-Hung, 235 New Taipei City (TW); LIU, Lei-Lei, 235 New Taipei City (TW)
(74) Representative: Dantz, Jan Henning

(57) **Abstract**

A cooling module 100 used in conjunction with a heating element 10 includes a vapor chamber 110 and a plurality of cooling fins 200. The vapor chamber 110 is in contact with one side of the heating element 10. The vapor chamber 110 is disposed with a direct conduction area 120 and a vacuum block 130 disposed on two sides of the direct conduction area 120 respectively. Each vacuum block 130 forms a chamber 170. The cooling fins 200 protrude from and are vertically disposed on the direct conduction area 120 and each vacuum block 130, respectively. Thereby, the effects of fast vertical heat transfer to the fin and fast horizontal heat transfer to the distal cooling fins are achieved.

## Description

### Technical Field

The disclosure relates to a cooling module, more particularly to a cooling module, a water-cooled cooling module and a cooling system which are capable of fast vertical and horizontal heat transfer.

### Background

Cooling technology is in line with the development of electronic products. During the operation of the electronic products, current in the circuit generates undesirable heat due to the impedance. When this heat cannot be dissipated effectively and goes to the electronic components inside the electronic products, it may damage these electronic components because of rising temperature. Hence, it is essential to dissipate the heat of the electronic components by, for example, the vapor chamber.

The conventional vapor chamber comprises a case in a rectangular shape and a capillary structure inside the chamber wall. Working fluid is filled into the inside of the case. One side of the case (namely the evaporation area) is attached to and abstracts heat generated by a heating element (e.g. a CPU or north and south bridge chips). Thus, the working fluid (in liquid) evaporates at the evaporation area of the case and is converted into gas, and therefore transfers heat to the other side of the case (namely the condensing area). The working fluid (gas) is condensed into liquid by cooling at the condensing area. Then, the working fluid (liquid) flows back to the evaporation area by gravity or capillary structure, to form the circulation for uniform temperature and heat dissipation.

Although the conventional vapor chamber can transfer heat evenly, it fails to transfer heat to a distal end to dissipate heat, like a heat pipe. This makes the vapor chamber only useful in uniform heat transfer in large areas and not applicable to a heat transfer to a distal end. In other words, the conventional vapor chamber transferring heat along the X axis and Y axis is better than that transferring heat along the Z axis. Additionally, the conventional water-cooled cooling module pumps the coolant into the case by a pump and the coolant goes to the cooling fins directly. This way, the coolant is unable to flow to each cooling fin evenly and the water pressure of the coolant on each cooling fin is not even. Thereby, the conventional water-cooled cooling module fails to dissipate heat of each cooling fin effectively and this increases the temperature of the electronic device, which affects its performance negatively.

### SUMMARY

One goal of the disclosure is to provide a cooling module, a water-cooled cooling module and a cooling system capable of fast vertical heat transfer to the fin and fast horizontal heat transfer to the distal cooling fins.

To reach this goal, the disclosure provides a cooling module, used in conjunction with a heating element, comprising a vapor chamber and a plurality of cooling fins. The vapor chamber is in contact with one side of the heating element. The vapor chamber is disposed with a direct conduction area and a vacuum block disposed on two sides of the direct conduction area respectively. Each vacuum block forms a chamber. The cooling fins protrude from and are vertically disposed on the direct conduction area and each vacuum block, respectively.

Furthermore, a water-cooled cooling module used in conjunction with a heating element comprises a vapor chamber in contact with one side of the heating element, a plurality of cooling fins and a water-cooled device. The vapor chamber is disposed with a direct conduction area and a vacuum block disposed on two sides of the direct conduction area respectively, wherein each vacuum block forms a chamber. The cooling fins protrude from and are vertically disposed on the direct conduction area and each vacuum block, respectively. The water-cooled device is sleeved on the vapor chamber and covers each cooling fin. The water-cooled device has a water inlet and a water outlet.

Moreover, a cooling system used in conjunction with a heating element comprises a vapor chamber in contact with one side of the heating element, a plurality of cooling fins, a water-cooled device, a pump and a heat sink. The vapor chamber is disposed with a direct conduction area and a vacuum block is disposed on two sides of the direct conduction area respectively, wherein each vacuum block forms a chamber. The cooling fins protrude from and are vertically disposed on the direct conduction area and each vacuum block, respectively. The water-cooled device is sleeved on the vapor chamber and covers each cooling fin. The water-cooled device has a water inlet and a water outlet. The pump is connected with the water outlet. The heat sink is connected to the water inlet.

### BRIEF DESCRIPTION OF THE DRAWINGS

The disclosure will become more fully understood from the detailed description and the drawings given herein below for illustration only, and thus does not limit the disclosure, wherein:
FIG. 1 is a perspective view of the first embodiment of the disclosure;
FIG. 2 is a sectional view of the first embodiment of the disclosure;
FIG. 3 is a perspective view of the second embodiment of the disclosure;
FIG. 4 is a sectional view of the second embodiment of the disclosure;
FIG. 5 is a sectional view of the second embodiment of the disclosure from another angle;
FIG. 6 is a sectional view of the second embodiment of the disclosure further with a pump disposed thereon;
FIG. 7 is a perspective view of the third embodiment of the disclosure; and
FIG. 8 is a sectional view of another embodiment of the disclosure.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

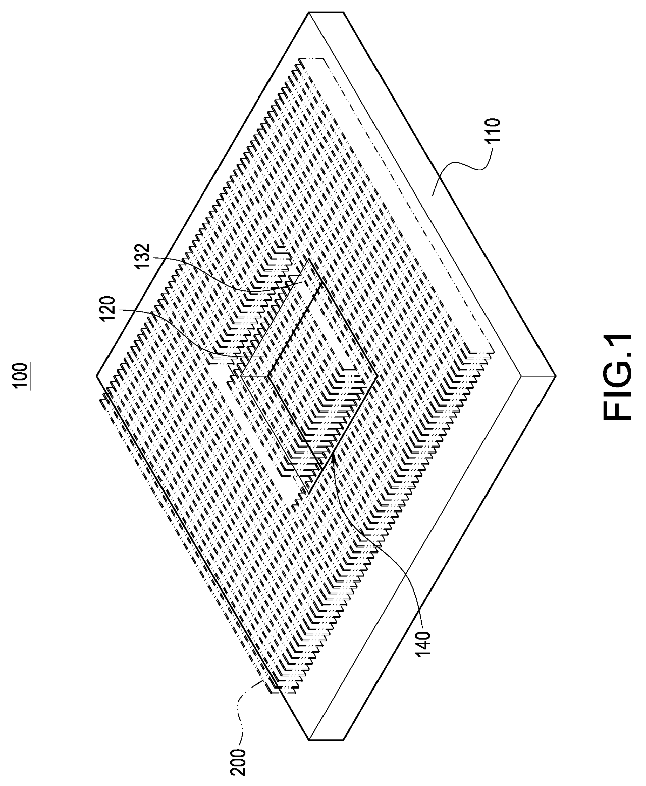

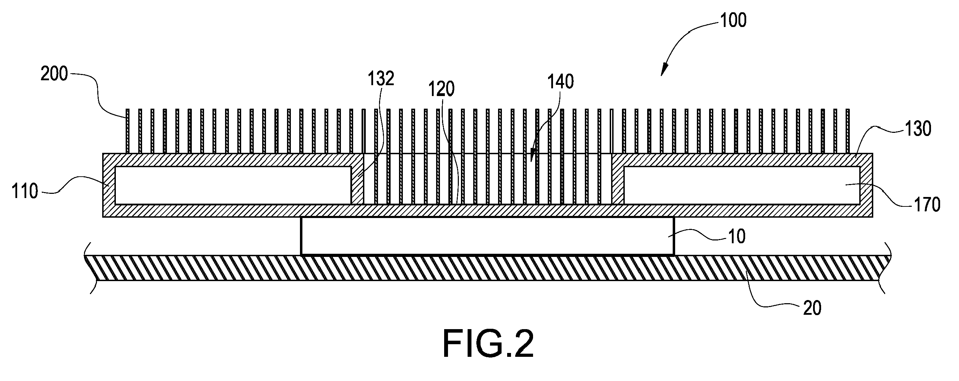

As seen in FIG. 1 and FIG. 2, the disclosure provides a cooling module 100, used in conjunction with a heating element 10. The heating element 10 refers to a chip or a CPU disposed on the substrate 20 which is a mother board or a circuit board. The cooling module 100 comprises a vapor chamber 110 and a plurality of cooling fins 200. The vapor chamber 110 is in contact with one side of the heating element 10. The vapor chamber 110 is disposed with a direct conduction area 120 and a vacuum block 130 disposed on two sides of the direct conduction area 120 respectively. Each vacuum block 130 forms a chamber 170. Each cooling fin 200 respectively protrudes from and is disposed on the direct conduction area 120 and each vacuum block 130 vertically.

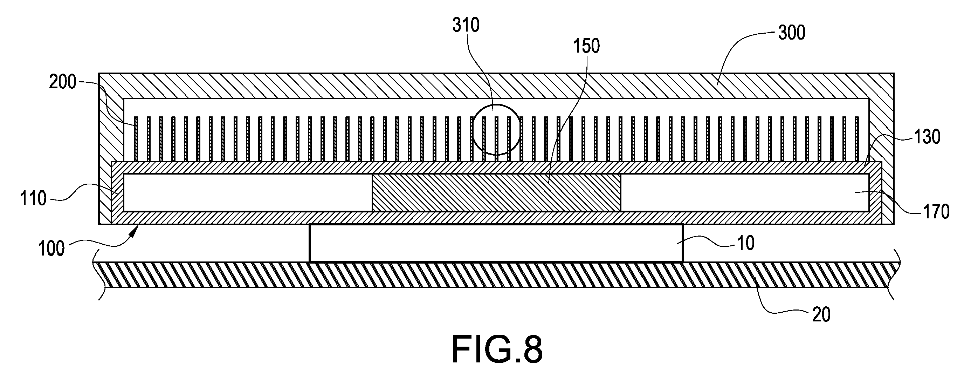

The direction conduction area 120 comprises a concave 140 roughly at the center of the vapor chamber 110 or a transfer medium 150 (as shown in FIG. 8). In the embodiments of FIG. 1 and FIG. 2, the direct conduction area 120 is preferably to be the concave 140 and the shape thereof is, but not limited to, rectangular. A separation plate 132 is disposed around each vacuum block 130. The separation plate 132 faces downwardly and is sealed with the bottom surface of the vapor chamber 110 vertically, from the upper surface of the vapor chamber 110. That is, the bottom surface of the vapor chamber 110 and each separation plate 132 surround and form the concave 140. Generally speaking, the vapor chamber 110 and the separation plate 132 are made of copper, aluminum or an alloy thereof and are integrally formed. The chamber 170 is preferably to be a vacuum chamber for increasing the speed of heat transfer.

Moreover, the size of the direct conduction area 120 is preferably to be smaller than that of the heating element 10. In other words, the ends of the heating element 10 go over the direct conduction area 120 to the vacuum block 130, so that the heat of the heating element 10 can be transferred horizontally to the cooling fins 200 at the distal end via the vacuum block 130, which improves the efficiency of heat dissipation. In this embodiment, the direction conduction area 120 takes the advantage of the material of the vapor chamber 110 to dissipate heat vertically to the cooling fins 200 rapidly, thereby dissipating heat.

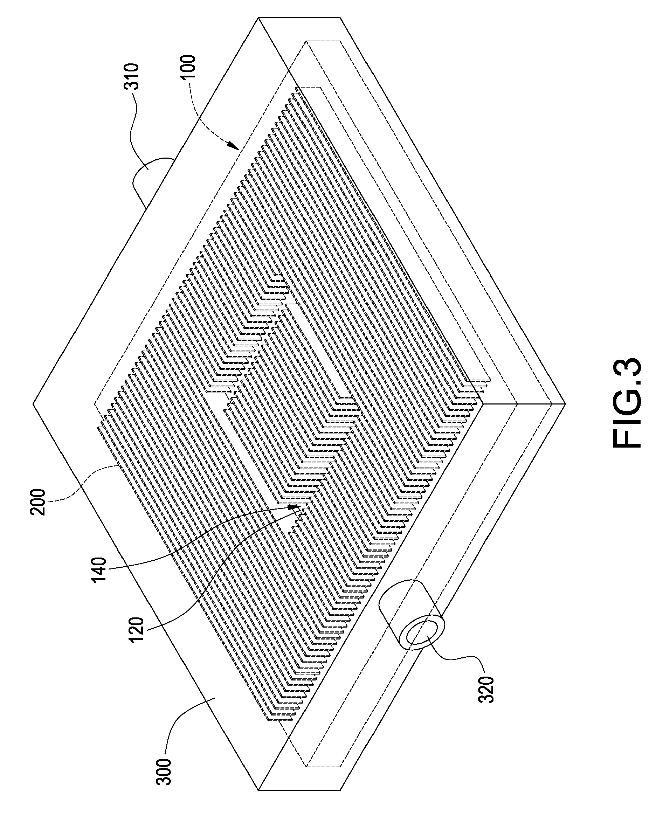

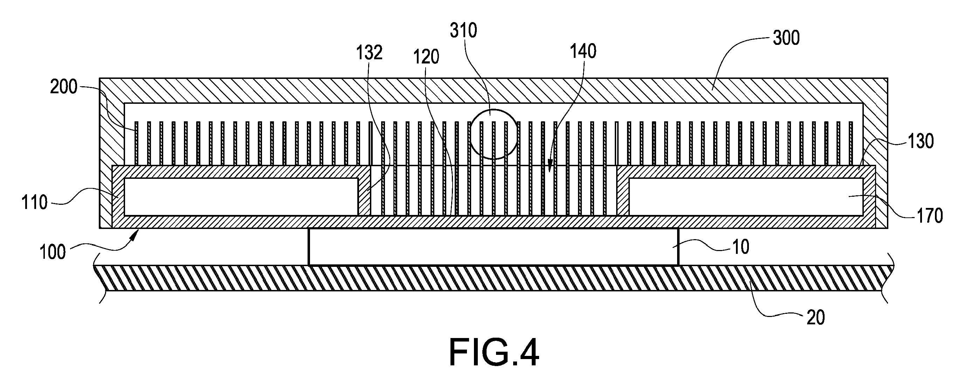

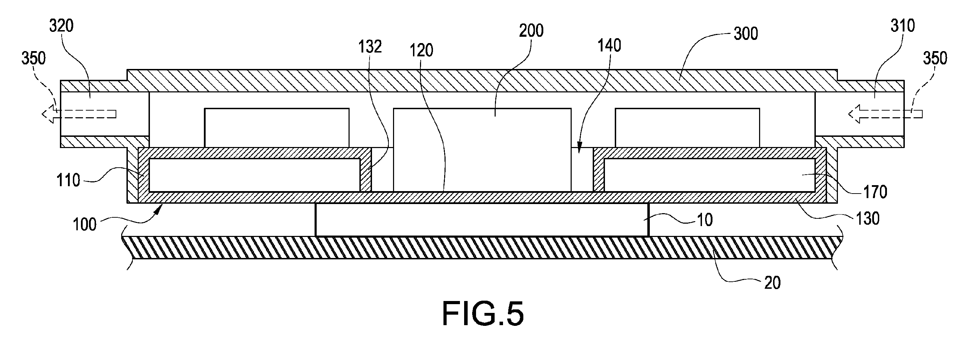

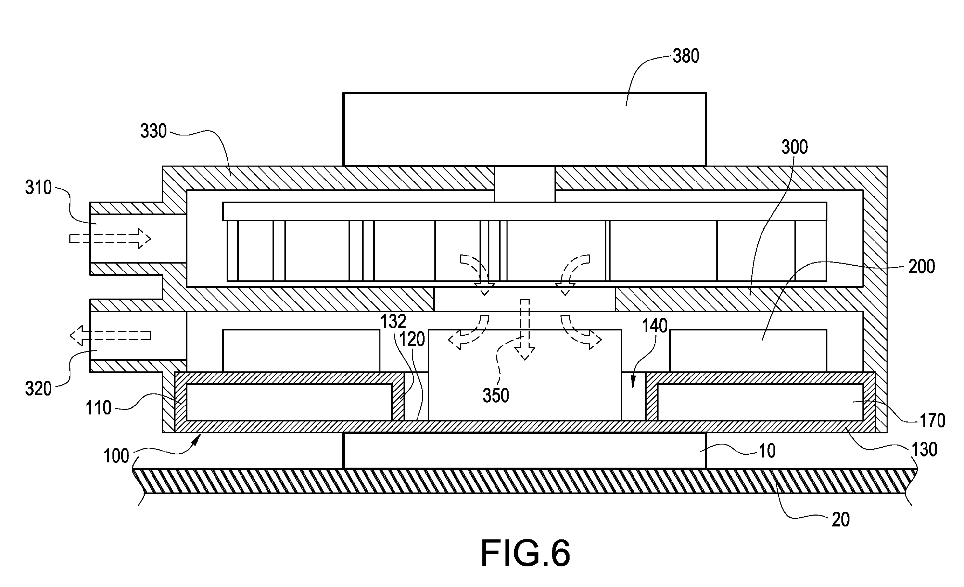

FIG. 3, FIG. 4 and FIG. 5 show the second embodiment of the disclosure. The disclosure further provides a water-cooled cooling module 100. Similarly, it used in conjunction with a heating element 10. The differences between this embodiment and previous embodiment lie in that a water-cooled device 300 is further disposed. The rest structures are shown before so it will not be illustrated again. In the embodiment shown in FIG. 5, the water-cooled device 300 is sleeved on the vapor chamber 110 and covers each cooling fin 200. Besides, the water-cooled device 300 has a water inlet 310 and a water outlet 320 which preferably are disposed on two ends of the water-cooled device 300. However, the water inlet 310 and the water outlet 320 in the embodiment shown in FIG. 6 are disposed on the same side of the water-cooled device 300 so the disclosure is not limited to a specific structure thereof.

In this embodiment, the direction conduction area 120 is preferably to be a concave 140 located at the center of the vapor chamber 110. Additionally, a separation plate 132 is disposed around each vacuum block 130. From the upper surface of the vapor chamber 110, the separation plate 132 faces downwardly and is sealed with the bottom surface of the vapor chamber 110 vertically,

Referring to FIG. 6, the water-cooled device 300 further comprises a pump 330 and a working fluid 350. The pump 330 is preferably disposed above the water-cooled device 300 and connects with the water-cooled device 300, so as to allow the working fluid 350 to flow therein. The working fluid 350 is preferably to be a coolant. The water inlet 310 is disposed on one side of the pump 330 while the water outlet 320 is disposed on another side of the water-cooled device 300. The working fluid 350 inputs from the water inlet 310 and outputs from the water outlet 320 so the working fluid 350 takes the heat away from the cooling fins 200. In this embodiment, a cooling fan 380 may be further added to the top of the pump 330 for improving the cooling rate.

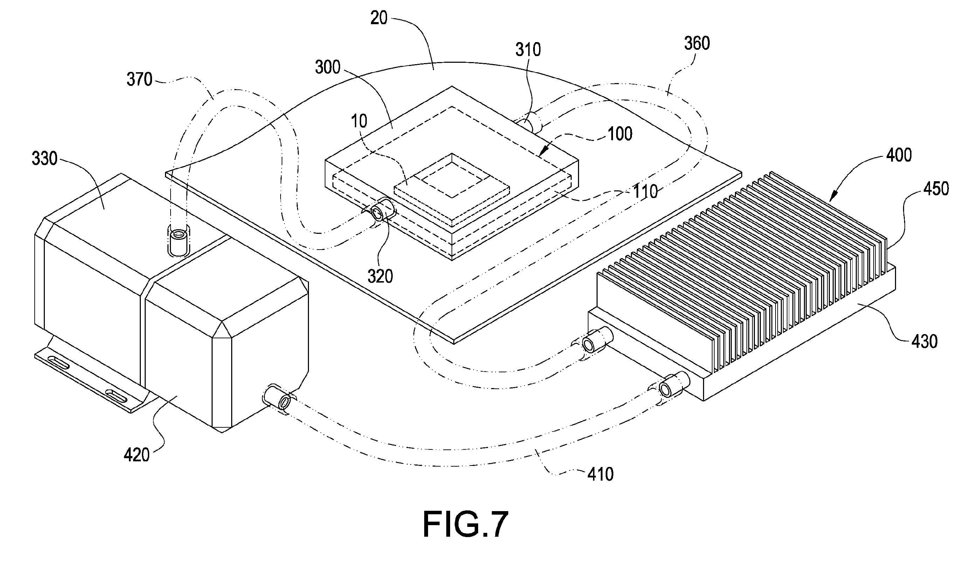

FIG. 7 is a perspective view of the third embodiment of the disclosure. The disclosure provides a cooling system used in conjunction with a heating element 10. The cooling system comprises a vapor chamber 110, a plurality of cooling fins (not shown in the figures), a water-cooled device 300, a pump 330 and a heat sink 400. The rest structures are illustrated in previous embodiments so they will not be illustrated here again.

In this embodiment, the pump 330 is preferably to be connected with the water outlet 320 while the heat sink 400 is connected to the water inlet 320. As seen in FIG. 7, the pump 330 is connected to the water outlet 320 via the pipeline 370 while the heat sink 400 is connected to the water inlet 310 via the pipeline 360. A water tank 420 for accommodating a working fluid 350 is disposed on one side of the pump 330, and the heat wink 400 comprises a heat exchange chamber 430 and a plurality of fins 450.

Additionally, this embodiment further comprises a connection pipeline 410 connecting the heat sink 400 and the pump 330. When the cooling system utilizes the water-cooled device 300 (e.g. when the water block is attached to the heating element 10), the pump 330 makes the working fluid 350 (namely, coolant) flow into the cooling module 100 via the water tank 420, in which it flows through the heat exchange chamber 430 and fins 450 and finally into the cooling module 100. The working fluid 350 takes the heat of the heating element 10 away from the water-cooled device 300 and the coolant goes to the water tank 420 via the water block, then back to the heat sink 400. Thereby, the circulation of coolant is formed for improving heat dissipation and this therefore reduces the temperature of the heating element 10.

Furthermore, FIG. 8 is another preferable embodiment of the disclosure. In this embodiment, the direct conduction area 120 is preferably to be a solid transfer medium 150 and the material thereof is copper, aluminum or an alloy thereof.

## Claims

1. A cooling module used in conjunction with a heating element 10, comprising:
a vapor chamber 110 in contact with one side of the heating element 10, wherein the vapor chamber 110 is disposed with a direct conduction area 120 and a vacuum block 130 disposed on two sides of the direct conduction area 120 respectively, wherein each vacuum block 130 forms a chamber 170; and
a plurality of cooling fins 200 protruding from and vertically disposed on the direct conduction area 120 and each vacuum block 130, respectively.

2. The cooling module according to claim 1, wherein the direct conduction area comprises a concave 140 or a transfer medium 150 located at the center of the vapor chamber 110.

3. The cooling module according to claim 2, wherein a separation plate 132 is disposed around each vacuum block 130, the separation plate 132 faces downwardly and is sealed with the bottom surface of the vapor chamber 110 vertically, from the upper surface of the vapor chamber 110.

4. The cooling module according to claim 2, wherein the transfer medium 150 is solid and the material thereof is copper, aluminum or an alloy thereof.

5. The cooling module according to claim 1, wherein the size of the direct conduction area 120 is smaller than the size of the heating element 10.

6. A water-cooled cooling module used in conjunction with a heating element 10, comprising:
a vapor chamber 110 in contact with one side of the heating element 10, wherein the vapor chamber 110 is disposed with a direct conduction area 120 and a vacuum block 130 disposed on two sides of the direct conduction area 120 respectively, wherein each vacuum block 130 forms a chamber 170;
a plurality of cooling fins 200 protruding from and vertically disposed on the direct conduction area 120 and each vacuum block 130, respectively; and
a water-cooled device 300 sleeved on the vapor chamber 110 and covering each cooling fin 200, the water-cooled device 300 having a water inlet 310 and a water outlet 320.

7. The water-cooled cooling module according to claim 6, wherein the water-cooled device 300 further comprises a pump 330 and a working fluid 350, the water inlet 310 is disposed on one side of the pump 330 while the water outlet 320 is disposed on another side of the water-cooled device 300, the working fluid 350 inputs to the water inlet 310 and outputs from the water outlet 320.

8. The water-cooled cooling module according to claim 6, wherein the direct conduction area 120 comprises a concave 140, a separation plate 132 is disposed around each vacuum block 130, and the separation plate 132 faces downwardly and is sealed with the bottom surface of the vapor chamber 110 vertically, from the upper surface of the vapor chamber 110.

9. The water-cooled cooling module according to claim 7, wherein the working fluid 350 is a coolant.

10. The water-cooled cooling module according to claim 7, wherein the pump 330 is disposed above the water-cooled device 300 and connects with the water-cooled device 300, so as to allow the working fluid 350 to flow therein.

11. A cooling system used in conjunction with a heating element 10, comprising:
a vapor chamber 110 in contact with one side of the heating element 10, wherein the vapor chamber 110 is disposed with a direct conduction area 120 and a vacuum block 130 disposed on two sides of the direct conduction area 120 respectively, wherein each vacuum block 130 forms a chamber 170;
a plurality of cooling fins 200 protruding from and vertically disposed on the direct conduction area 120 and each vacuum block 130, respectively;
a water-cooled device 300 sleeved on the vapor chamber 110 and covering each cooling fin 200, the water-cooled device 300 having a water inlet 310 and a water outlet 320;
a pump 330 connected with the water outlet 320; and
a heat sink 400 connected to the water inlet 310.

12. The cooling system according to claim 11, further comprising a connection pipeline 410 connected to the heat sink 400 and the pump 330 respectively.

13. The cooling system according to claim 12, wherein the pump 330 is disposed with a water tank 420 accommodating a working fluid 350, the connection pipeline 410 is connected to the heat sink 400 and the water tank 420.

14. The cooling system according to claim 11, wherein the heat sink 400 comprises a heat exchange chamber 430 and a plurality of fins 450.
